# EUROPEAN PATENT APPLICATION

(11) **EP 3 012 870 A1**
(43) Date of publication of application: **27.04.2016**
(21) Application number: 14189527.6
(22) Date of filing: 20.10.2014
(51) Int. Cl.: H01L 29/872, H01L 29/06, H01L 29/36, H01L 29/24

(54) **Edge termination for high voltage semiconductor devices**

(71) Applicant: ABB Technology AG, 8050 Zürich (CH)
(72) Inventor: Mihaila, Andrei, 5400 Baden (CH); Sundaramoorthy, Vinoth, 5430 Wettingen (CH); Bartolf, Holger, 5200 Brugg (CH)
(74) Representative: ABB Patent Attorneys

(57) **Abstract**

There is provided a high power semiconductor device with an edge termination technique which requires less wafer area and is less sensitive to doping level and positional variations. The device comprises a semiconductor wafer (W), the wafer (W) having an active region (AR) and a termination region (TR) laterally surrounding the active region (AR), wherein a plurality of junction termination extension rings (20) and a plurality of guard rings (25) are formed in the termination region (TR), wherein the number of guard rings is less than the number of termination extension rings, each one of the junction termination extension rings (20) and of the guard rings (25) is a ring-shaped semiconductor region of the first conductivity type, which is laterally surrounding the active region (AR), the junction termination extension rings (20) are spaced from each other in the lateral direction, the guard rings (25) are spaced from each other in the lateral direction, the innermost guard ring (25) laterally surrounds the innermost junction termination extension ring (20), at least two junction termination extension rings (20) laterally surround the outermost guard ring (25), and the guard rings (25) have a doping concentration which is 5·10¹⁸ cm⁻³ or higher and the junction termination extension rings (20) have a doping concentration which is 8·10¹⁷ cm⁻³ or lower.

## Description

### FIELD OF THE INVENTION

The present invention relates to a high power semiconductor device comprising a plurality of guard rings in a termination region laterally surrounding the active region of a semiconductor wafer.

### BACKGROUND OF THE INVENTION

Semiconductor devices, in particular high power semiconductor devices, require an efficient edge termination to avoid electric field crowding at the edge of the main contact resulting in breakdown of the device at a relatively low breakdown voltage VBR. In practice, a breakdown voltage VBR of the device shall be at least 80% of the theoretical bulk breakdown value.

4H-SiC is an attractive material for high power semiconductor devices due to its ten times higher critical electrical field than that of silicon. Known edge termination techniques include junction termination extension (JTE), floating field rings (FFRs) or guard rings, field plates, mesa structures, high resistive layer and combinations of these techniques. Among these edge termination techniques, floating field rings and the junction termination extension are the most commonly used edge termination techniques in 4H-SiC based high power devices.

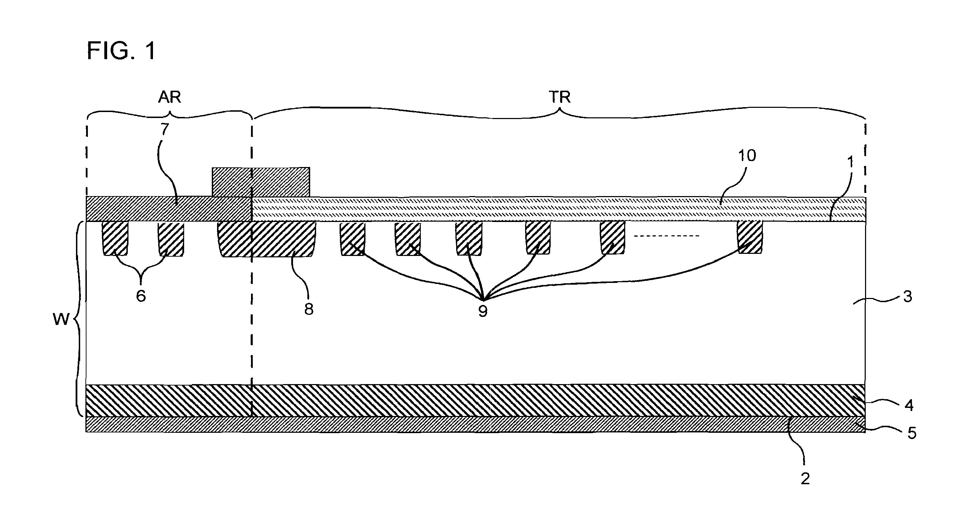

In Fig. 1 there is shown a junction barrier Schottky (JBS) diode with floating field rings as an edge termination. The shown JBS diode comprises a semiconductor wafer W having a first main side surface 1 and a second main side surface 2 parallel to the first main side surface 1. The semiconductor wafer W has a low-doped n⁻ drift layer 3 and a highly doped n⁺ substrate layer 4 formed in the order from the first main side surface 1 to the second main side surface 2. On the second main side surface 2 of the semiconductor wafer W there is formed a back metallization layer 5 as a cathode electrode which forms an ohmic contact with the highly doped n⁺ substrate layer 4. In the active region AR there are formed anode layer portions 6 adjacent to the first main side surface 1 of the active region AR of the semiconductor device. On the first main side surface 1 there is formed a top metallization layer 7 as an anode electrode forming an ohmic contact with the p⁺ anode layer regions 6 and forming a Schottky contact with the n⁻ drift layer 3 in the active region AR. Along the outer edge of the active region AR there is formed a highly doped p⁺ junction termination ring 8 adjacent to the first main side surface 1. The p⁺ junction termination ring 8 is in direct contact with the anode electrode 7. In the termination region TR laterally surrounding the active region AR there is formed a plurality of highly doped p⁺ rings 9 adjacent to the first main side surface 1. The p⁺ rings 9 are spaced from each other and are also spaced from the junction termination ring 8. In the termination region TR the first main side surface 1 is covered by a passivation layer 10. The purpose of the p⁺ rings 9 in the termination region TR is to alleviate the field crowding effect at the outer edges of the device main junction by allowing the depletion region to extend through consecutively lower biased floating junctions. To be effective, the distances between these p⁺ rings 9 as well as their width in the lateral direction have to be thoroughly optimized to achieve an even distribution of the electric field.

In addition, the effect of the p⁺ rings 9 is very sensitive to the influence of parasitic surface charges which inherently result from the processing conditions during the manufacturing of the JBS diode.

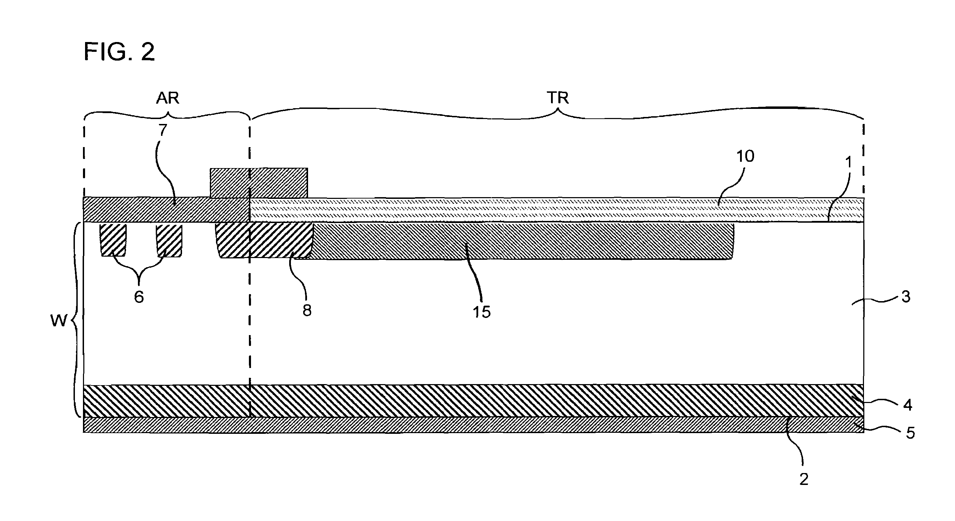

In Fig. 2 there is shown another known JBS diode which uses the junction termination extension instead of the p⁺ rings as an edge termination technique. In Fig. 2 the same reference signs are used for elements which are similar to that of the JBS diode as shown in Fig. 1. In the device shown in Fig. 2 there is formed a wide low-doped p⁻ junction termination extension (JTE) 15 adjacent to the first main side surface 1. This JTE 15 is in direct contact with and surrounding the p⁺ junction termination ring 8. The effect of the JTE 15 is to decrease the electric field pressure on the outer edge of the main junction by evenly distributing the potential along the width of the JTE 15. To be effective, the JTE edge termination technique needs very accurate control of the doping concentration or implantation dose of the JTE 15. When implanting the dopant for forming the JTE 15 by ion implantation in a 4H-SiC based high power device one cause for variations in the doping concentration is that the activation level of the implanted impurities is difficult to control. Another disadvantage of the JTE termination technique is that it requires a relatively large wafer area.

In prior art document US 6,831,345 B2 there is described an edge termination technique which aims at minimizing the dependency of the breakdown voltage VBR on the doping concentration of the JTE by forming two or more inner p⁺ rings embedded inside of a wide RESURF layer surrounding the active region of the device. Further it is disclosed in this prior art document to form additional low-doped p- rings surrounding the RESURF layer with a gap formed between the RESURF layer and the p⁻ rings as well as gaps formed between each two neighboring p⁻ rings. However, this modified JTE edge termination technique has the disadvantage that it cannot achieve a high breakdown voltage VBR without using a large wafer area. Further, there is still a significant dependency of the breakdown voltage on the doping concentration of the RESURF layer as well as on positional variations of the different p⁺ and p⁻ rings.

From prior art document US 8,124,480 B2 there is known an edge termination technique for silicon carbide devices with a plurality of concentric floating guard rings that are adjacent and spaced apart from a silicon carbide-based semiconductor junction. An insulating layer such as an oxide, is provided on the floating guard rings and a p-type silicon carbide surface charge compensation region is provided between the floating guard rings and adjacent the insulating layer. According to US 8,124,480 B2 the silicon carbide surface charge compensation region is a p-type silicon carbide region. The edge termination technique described in US 8,124,480 B2 has the same disadvantages as the prior art discussed with Fig. 1 above. Further, the p-type silicon carbide surface charge compensation region cannot fully compensate for surface charges at the interface between silicon carbide wafer surface and the oxide layer formed thereon.

### SUMMARY OF THE INVENTION

It is the object of the invention to provide a high power semiconductor device with an edge termination technique which requires less wafer area, is less sensitive to doping variations, is less sensitive to space variations of the structures involved in the edge termination and is also less sensitive to parasitic charges.

The object of the invention is attained by a high power semiconductor device according to claim 1.

The edge termination technique used in the high power semiconductor device according to claim 1 is less dependent on the doping concentration in the JTE rings than any known edge termination technique using one or more low doped JTE rings. Further, it requires less wafer area and is less sensitive to space variations in the dimensions of the involved structures than any other known edge termination technique.

Further developments of the invention are specified in the dependent claims.

In a preferred embodiment, the innermost guard ring links the two innermost junction termination extension rings so that the two innermost junction termination extension rings and the innermost guard ring form a single continuous ring-shaped semiconductor region of the first conductivity type. This can further reduce the required space and optimize the sensitivity to space and doping variations.

In a preferred embodiment a first pair of two neighboring junction termination extension rings is linked by a first guard ring and a second pair of two neighboring junction termination extension rings is linked by a second guard ring, wherein the first and the second pair of junction termination extension rings include four neighboring junction termination extension rings, and wherein the first and the second guard ring are two neighboring guard rings.

In a preferred embodiment, the width of the guard rings in the lateral direction is in a range of 1 µm to 5 µm.

In a preferred embodiment, the width of the junction termination extension rings in the lateral direction is in a range of 2 µm to 10 µm.

In a preferred embodiment the depth of the junction termination extension rings to which they extend from the first main side surface is in a range between 0.4 and 2 µm.

In a preferred embodiment the number of the junction termination extension rings is between 10 and 150.

In a preferred embodiment the number of the guard rings is between 2 and 50.

In a preferred embodiment the innermost junction termination extension ring laterally surrounds the first semiconductor layer at a distance which is in a range between 0.5 and 5 µm.

In a preferred embodiment the guard rings are buried in the wafer separated from the first main side surface of the wafer at a distance of between 0.2 to 2 µm, preferably at a distance of between 0.2 and 1.5µm.

In a preferred embodiment the distance between the junction termination extension rings in the lateral direction is in a range of between 0.5 and 5 µm.

In a preferred embodiment, the high power semiconductor device includes at least two guard rings and the distance between each pair of neighbouring guard rings in the lateral direction is at least 3 µm.

In a preferred embodiment the first semiconductor layer comprises a ring shaped semiconductor region which is formed along the edge of the active region and which is in direct contact with the first electrode.

In a preferred embodiment a charge compensation film is formed in the termination region of the wafer at the first main side surface of the wafer, and wherein the charge compensation film is a semiconductor film of the second conductivity type having a doping concentration which is higher than that of the second semiconductor layer. This can significantly reduce the dependency of the breakdown voltage on manufacturing conditions resulting in surface charges. In particular, the depletion of the junction termination extension rings is improved and premature avalanche breakdown due to a peak occurring at the edge of the outermost junction termination extension ring can be avoided.

In a preferred embodiment the distance between neighbouring junction termination extension rings, which are not linked by a guard ring, is increasing stepwise or continuously from the innermost pair of junction termination extension rings to the outermost pair of junction termination extension rings.

### BRIEF DESCRIPTION OF THE DRAWINGS

Detailed embodiments of the invention will be explained below with reference to the accompanying figures, in which:
- Fig. 1: shows a known junction barrier Schottky (JBS) diode with floating field rings as an edge termination;
- Fig. 2: shows another known JBS diode which uses a junction termination extension as an edge termination technique;
- Fig. 3: illustrates a first embodiment of the high power semiconductor device with an edge termination technique according to the invention;
- Fig. 4: shows a second embodiment of the high power semiconductor device with another edge termination technique according to the invention;
- Fig. 5: shows a third embodiment of the high power semiconductor device with another edge termination technique according to the invention;
- Fig. 6: shows a fourth embodiment of the high power semiconductor device with another edge termination technique according to the invention;
- Fig. 7: shows a fifth embodiment of the high power semiconductor device with another edge termination technique according to the invention; and
- Fig. 8: shows a sixth embodiment of the high power semiconductor device with another edge termination technique according to the invention.

The reference signs used in the figures and their meanings are summarized in the list of reference signs. Generally, similar elements have the same reference signs throughout the specification. The described embodiments are meant as examples and shall not limit the scope of the invention.

### DETAILED DESCRIPTION OF PREFERRED EMBODIMENTS

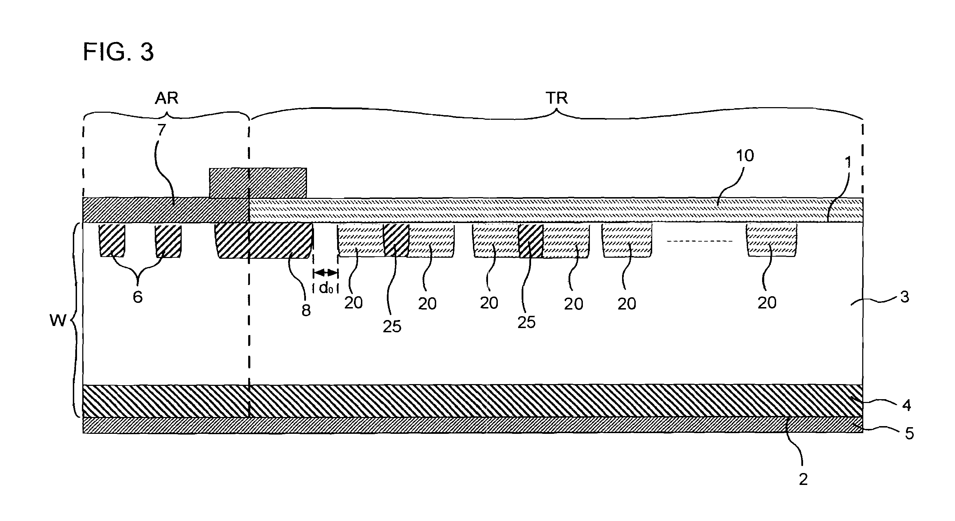

In Fig. 3 there is shown a silicon carbide (SiC) JBS diode with an edge termination technique according to a first embodiment of the invention. Similar to the JBS diodes of the prior art shown in Fig. 1 and Fig. 2, respectively, the high power semiconductor device according to the first embodiment of the invention comprises a semiconductor wafer W, wherein the wafer W is made of SiC and has a first main side surface 1 and a second main side surface 2, which is parallel to the first main side surface 1 and extending in a lateral direction. The wafer W has an active region AR and a termination region TR laterally surrounding the active region AR.

In the order from the first main side surface 1 to the second main side surface 2 the semiconductor wafer W has a low-doped n⁻ drift layer 3 and a highly doped n⁺ substrate layer 4. The doping concentration of the n⁻ drift layer 3 can vary between 1·10¹⁴ cm⁻³ and 8.10¹⁶ cm⁻³ with a thickness between 5 µm and 400 µm. The n⁺ substrate layer 4 has a doping concentration of 5·10¹⁸ cm⁻³ or higher and its thickness is in a range between 5 µm and 600 µm. On the second main side surface 2 of the semiconductor wafer W there is formed a back metallization layer 5 as a cathode electrode which forms an ohmic contact with the highly-doped n⁺ substrate layer 4.

In the active region AR there are formed anode layer portions 6 adjacent to the first main side surface 1 of the active region AR of the JBS diode. A top metallization layer 7 is formed on the first main side surface 1 as an anode electrode forming an ohmic contact with the p⁺ anode layer regions 6 and forming a Schottky contact with the n⁻ drift layer in the active region AR. Along the outer edge of the active region AR there is formed a highly doped p⁺ junction termination ring 8 adjacent to the first main side surface 1. The p⁺ junction termination ring 8 is in direct contact with the anode electrode 7. The highly doped p⁺ junction termination ring 8 forms a first semiconductor layer, the n⁻ drift layer forms a second semiconductor layer and the n⁺ substrate layer forms a third semiconductor layer, wherein the first to third semiconductor layers are arranged in this order from the first main side surface 1 to the second main side surface 2. In the first embodiment the p⁺ junction termination ring 8 and the p⁺ anode layer regions 6 have all a doping concentration of 5 · 10¹⁸ cm⁻³ or higher.

In the termination region TR laterally surrounding the active region AR there is formed a plurality of junction termination extension (JTE) rings 20, which are low-doped p⁻ ring-shaped semiconductor regions laterally surrounding the active region AR and the p⁺ junction termination ring 8. The JTE rings 20 are formed in direct contact with the first main side surface 1. That means that there is no gap nor any other semiconductor layer formed between the JTE rings 20 and the first wafer main side surface 1. The JTE rings 20 are spaced from each other in the lateral direction at a distance which is in a range of between 0.5 to 5 µm. The depth of the junction termination extension rings 20, to which they extend from the first main side surface 1 is in a range between 0.4 and 5 µm. That means that the distance between the lower end of the junction termination extension rings 20 and the upper end at the first main side surface 1 is between 0.4 and 5 µm. The width of the junction termination rings 20 in the lateral direction is in a range between 2 and 10 µm. The JTE rings 20 have a doping concentration which is 8 · 10¹⁷ cm⁻³ or lower. The peak concentration which is the maximum doping concentration in the JTE rings 20 is in a range between 1 · 1015 cm⁻³ and 8 · 10¹⁷ cm⁻³. In the first embodiment the innermost JTE ring 20 is spaced from the p⁺ junction termination ring 8 in a lateral direction with a distance do of 0.5 to 5 µm between the innermost JTE ring 20 and the p⁺ junction termination ring 8.

In the termination region TR there are further formed a plurality of highly doped p⁺ guard rings adjacent to the first main side surface 1 of the wafer W. The p⁺ guard rings are also ring-shaped semiconductor regions which laterally surround the active region AR and the p⁺ junction termination ring 8. In the first embodiment the p⁺ guard rings are, like the JTE rings 20, in direct contact with the first main side surface 1 of the wafer W. That means that there is no gap nor any other semiconductor layer formed between the p⁺ guard rings 25 and the first wafer main side surface 1. The guard rings 25 are spaced from each other in the lateral direction with a distance between each pair of neighboring guard rings 25 in the lateral direction of at least 3 µm, and preferably in a range from 3 µm to 10 µm. The width of the guard rings 25 in the lateral direction is in a range of 1 µm to 5 µm. In the first embodiment the depth of the guard rings, to which they extend from the first main side surface 1 is the same as the depth of the junction termination extension rings 20. The doping concentration of the guard rings 25 is 5 · 10¹⁸ cm⁻³ or higher. The guard rings 25 as well as the junction termination extension rings 20 are formed in the n- drift layer 3 so that each of them is in direct contact with the n⁻ drift layer 3. As can be seen from Fig. 3, each one of the guard rings 25 links two neighboring JTE rings 20 in such way that two neighboring JTE rings 20 and the linking guard ring 25 between this neighboring JTE rings 20 form a continuous p-type region. Specifically a first pair of two neighboring JTE rings 20 is linked by a first guard ring 25 and a second pair of two neighboring JTE rings 20 is linked by a second guard ring 25, wherein the first and the second pair of junction termination extension rings 20 include four neighboring junction termination extension rings, and wherein the first and the second guard ring are two neighboring guard rings. In the first embodiment shown in Fig. 3 the before mentioned first guard ring 25 is the innermost guard ring 20 and the before mentioned first pair of JTE rings 20 is the innermost pair of JTE rings 20.

Further, a passivation layer 10 is formed in the termination region TR on the first main side surface 1 to cover the first main side surface 1 in the termination region. The passivation layer 10 can be a non-conductive silicon oxide or silicon nitride layer or a high-k dielectric layer, for example. A portion of the passivation layer 10 is formed on a portion of the junction termination ring 8. This portion of the passivation layer 10 is at least partially covered with the top metallization layer 7. The top metallization layer does, however, not extend beyond the extension termination ring 8 in a lateral direction from the active region AR outwards to the termination region TR.

The first embodiment shown in Fig. 3 has two guard rings 25 and the number of JTE rings 20, of which there are shown six JTE rings 20 in Fig. 3, is higher than the number of guard rings 25. In the first embodiment Fig. 3 there more than three JTE regions which laterally surround the outermost guard ring 25. Only three of these JTE rings 20 which laterally surround the outermost guard ring 25 are shown in Fig. 3. Preferably, the number of JTE rings 20 is in a range between 10 and 150.

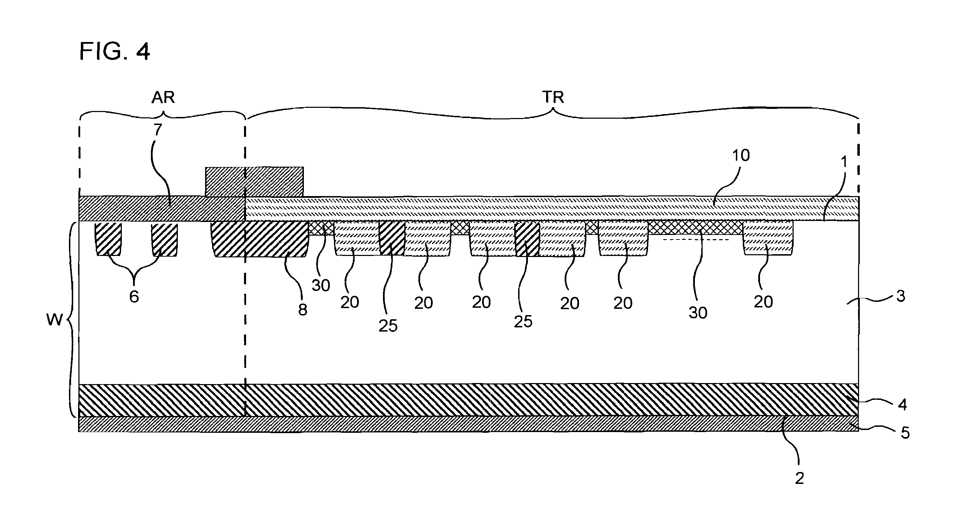

In Fig. 4 there is shown a second embodiment of the high power semiconductor device of the invention. Due to the many similarities between the first and the second embodiments only the differences between these embodiments are described. In the second embodiment there is additionally formed an n-type charge compensation layer 30 in the termination region TR of the wafer W at the first main side surface of the wafer W, wherein the charge compensation layer 30 has a doping concentration which is higher than that of the n⁻ drift layer 3. Preferably, the doping concentration of the charge compensation layer 30 is between 1 · 1015 cm⁻³ and 5 · 10¹⁷. The depth to which the charge compensation layer 30 extends from the first main side surface 1 of the wafer W is preferably in a range between 100 nm and 1 µm. In the embodiment shown in Fig. 4 the depth the charge compensation layer 30 (i.e. the distance of the lower end of the charge compensation layer 30 to the first main side surface 1 of the wafer W) is less than the depth of the JTE rings 20. The charge compensation layer 30 separates the passivation layer 10 from the n⁻ drift layer 3 at least in a region between the junction termination ring 8 and the outermost JTE ring 20 so that there is no direct contact between n- drift layer 3 and passivation layer 10 in this region between the termination ring 8 and the outermost JTE ring 20. In the second embodiment the charge compensation layer can avoid the negative effects of a negative parasitic charge at the interface between the semiconductor wafer W and the passivation layer 10 on the first main side surface 1 of the wafer W. In particular it was found out that in the embodiment with the charge compensation layer the depletion of the JTE rings 20 was improved and hence the negative gradient of the electric field within the JTE rings 20 in a lateral direction was higher within the charge compensation layer 30 compared to an embodiment without the charge compensation layer 30.

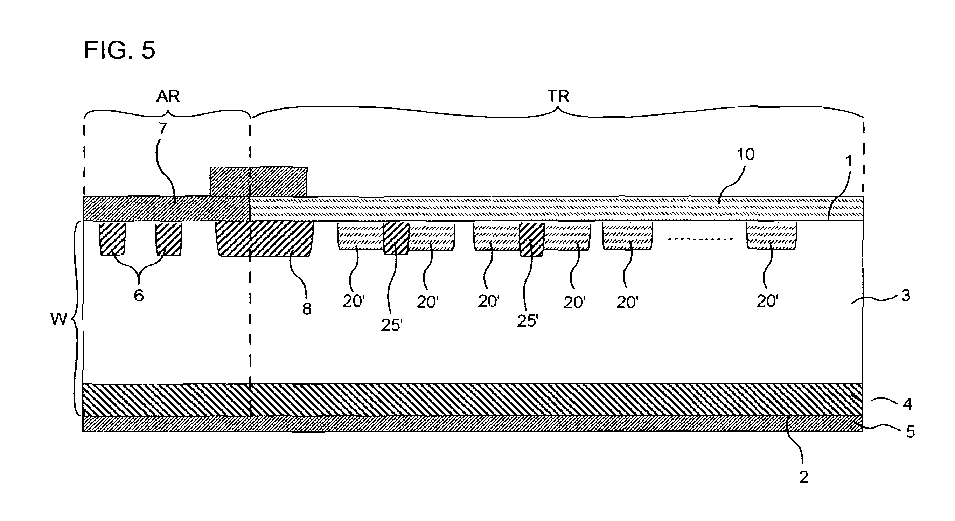

In Fig. 5 there is shown a third embodiment of the high power semiconductor device of the invention. Due to the many similarities between the first and the third embodiments only the differences between these embodiments are described. The third embodiment differs from the first embodiment only in that the depth to which guard rings 25' extend from the first main side surface 1 is deeper than the depth to which the JTE rings 20' extend from the first main side surface 1. That means that the distance of respective lower ends of the guard rings 25' from the first main side surface 1 is larger than the distance of respective lower end of the JTE rings 20' from the first main side surface 1.

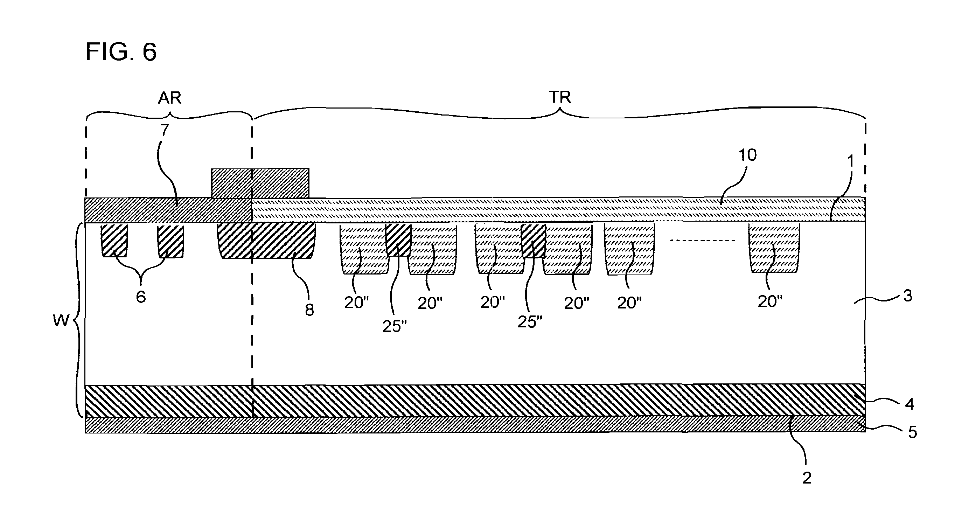

In Fig. 6 there is shown a fourth embodiment of the high power semiconductor device of the invention. Due to the many similarities between the first and the fourth embodiments only the differences between these embodiments are described. The fourth embodiment differs from the first embodiment only in that the depth to which guard rings 25" extend from the first main side surface 1 is more shallow than the depth to which the JTE rings 20" extend from the first main side surface 1. That means that the distance of respective lower ends of the guard rings 25" from the first main side surface 1 is smaller than the distance of respective lower end of the JTE rings 20" from the first main side surface 1.

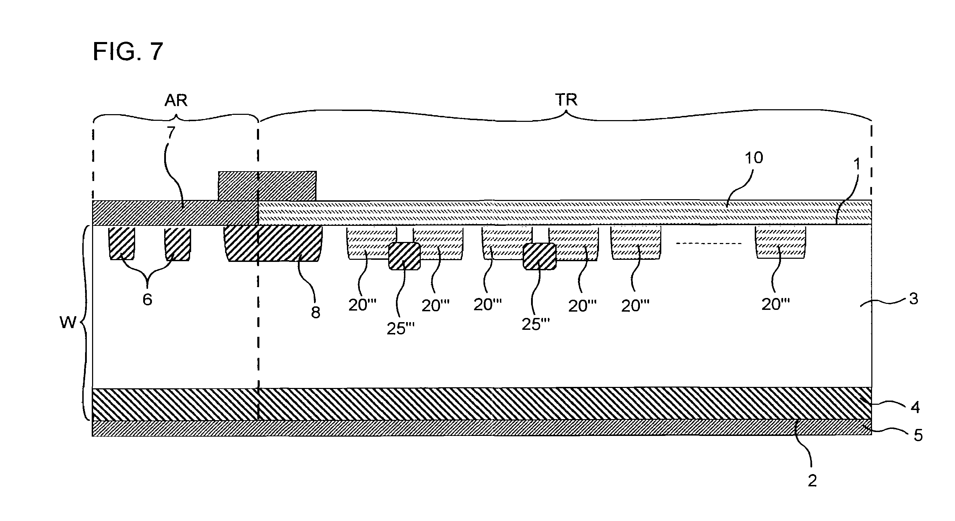

In Fig. 7 there is shown a fifth embodiment of the high power semiconductor device of the invention. Due to the many similarities between the first and the fifth embodiments only the differences between these embodiments are described. The fifth embodiment differs from the first embodiment only in that the guard rings 25"' are not in direct contact with the first main side surface 1 but separated therefrom with a distance of between 0.2 to 2 µm between each guard ring 25'" and the first main side surface 1. In other words the guard rings 25'" are buried in the wafer W to be separated from the first main side surface 1 with a distance of 0.2 to 2 µm there between, more preferably with a distance of 0.2 and 1.5µm there between.

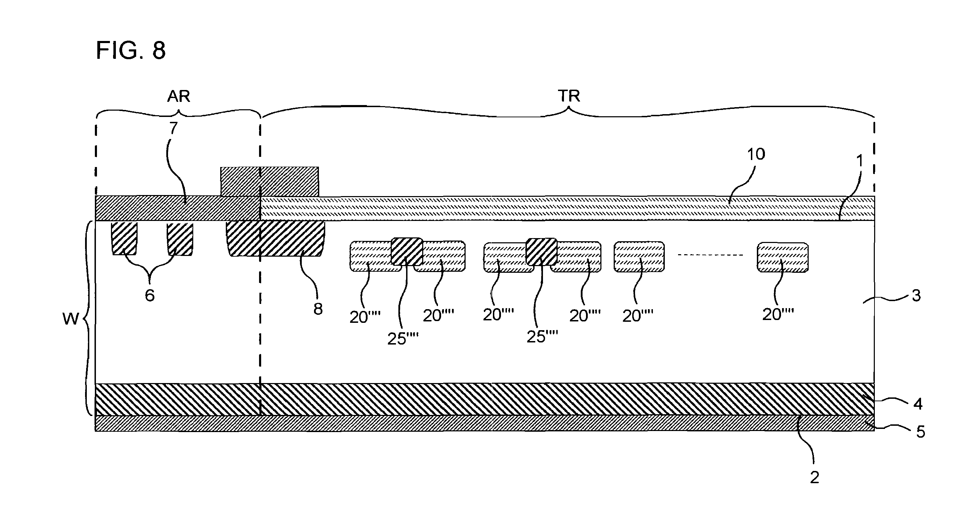

In Fig. 8 there is shown a sixth embodiment of the high power semiconductor device of the invention. Due to the many similarities between the first and the sixth embodiments only the differences between these embodiments are described. The sixth embodiment differs from the first embodiment only in that the guard rings 25"" and the JTE rings 20"" are not in direct contact with the first main side surface 1 but separated therefrom with a distance of between 0.2 to 2 µm between each guard ring 25"" and the first main side surface 1 as well as between each JTE ring 20"" and the first main side surface 1. In other words the guard rings 25"" and the JTE rings 20"" are buried in the wafer W to be separated from the first main side surface 1 with a distance of 0.2 to 2 µm to the first main side surface 1, more preferably with a distance of 0.2 and 1.5µm to the first main side surface 1.

It will be apparent for persons skilled in the art that modifications of the above described embodiments are possible without departing from the idea of the invention as defined by the appended claims.

In the above embodiments the number of the guard rings was always shown and described to be two. However, depending on the nominal (maximum) voltage of the device, any number of guard rings between two and 50 might be used. The higher the nominal voltage of the device the higher is the required number of guard rings and the number of required JTE rings. In any case, the number of guard rings always has to be less than the number of the JTE rings.

In the above embodiments each guard ring was described to link two neighboring JTE rings. However, it is not necessary that all guard rings link two neighboring guard rings. Further, in the above embodiments the guard rings were all linked with each other by respective JTE rings. However, a pair of neighboring JTE rings which is linked by a guard ring may not necessarily be linked to another JTE ring by another guard ring.

In the above described embodiments there are more than three JTE regions which laterally surround the outermost guard ring. However, at least two such JTE regions which laterally surround the outermost guard ring 25 would be sufficient to solve the problem of the invention. Preferably the number of JTE rings which laterally surround the outermost guard ring is at least three, more preferably at least four and even more preferably at least five.

All above described embodiments may be modified in that the distance in a lateral direction between neighboring junction termination extension rings (20), which are not linked by a guard ring (25), is increasing stepwise or continuously from the innermost pair of junction termination extension rings (20) to the outermost pair of junction termination extension rings (20).

In the above described embodiments silicon carbide was used as a semiconductor material. However, it is also possible to implement the high power semiconductor device of the invention with silicon or with a group-III-nitride semiconductor (AlGaInN) or with diamond.

In the above described embodiments the high power semiconductor device was a JBS diode. However the how power semiconductor device of the invention may be another high power semiconductor device such as an unipolar diode, a pin diode, a junction gate field-effect transistor (JFET), a metal-oxide-semiconductor field-effect transistor (MOSFET), an insulated gate bipolar transistor (IGBT), a bipolar junction transistor (BJT), or a thyristor.

In the above described embodiments the innermost JTE ring is spaced from the p⁺ junction termination ring in a lateral direction with a distance do of 0.5 to 5 µm between the innermost JTE ring and the p⁺ junction termination ring. While this is the preferable embodiment it would be also possible to have a direct contact between the innermost JTE ring and the p⁺ junction termination ring.

In the above described first embodiment the termination junction ring and the guard rings may all have the same doping concentration and may have all the same depth, so that they can be manufactured in the same implantation process step using only one mask. However the junction termination ring 8 can also have another doping concentration and another depth than the guard rings 6 if desired.

Likewise, in the above embodiments, the doping concentration of all JTE rings may be the same to facilitate the manufacturing of the JTE rings in on single process step using only one single mask.

In the above description the first embodiment it is described that the first semiconductor layer is the junction termination extension ring, but the first semiconductor layer can also extend into the AR to have another shape than a ring shape and include the ring-shaped junction termination ring just as a portion thereof.

In the second embodiment shown in Fig. 4 the charge compensation layer is in a lateral direction formed between the JTE rings and the guard rings as well as between the junction termination ring and the innermost JTE ring only. However, in another embodiment where the JTE rings and/or the guard rings are not in direct contact to the first main side surface of the wafer but buried in the semiconductor wafer, the charge compensation layer can also be formed as a layer which extends also in a region between the first main side surface and the JTE rings and/or the guard rings. In other words, the charge compensation layer can be formed as a layer separating the JTE rings and/or the guard rings from the first main side surface of the wafer. In case that both, the guard rings as well as the JTE rings are buried in the wafer, the charge compensation layer can be formed as a continuous layer.

In the above described embodiments, the width of the guard rings in the lateral direction was described to be in a range of 1 µm to 5 µm. In a preferred embodiment, the width of the guard rings is the same for all guard rings. In another preferred embodiment, the width of the guard rings is increasing from the innermost guard ring to the outermost guard ring stepwise or continuously.

In the above described embodiments, the width of the junction termination rings in the lateral direction was described to be in a range of 2 µm to 10 µm. In a preferred embodiment, the width of the guard rings is the same for all junction termination rings. In another preferred embodiment, the width of the junction termination rings is increasing from the innermost of the junction termination ring to the outermost junction termination ring stepwise or continuously.

In the claims, when a region is referred to as adjacent the first main side surface the region can be either in direct contact to the first main side surface or it can be near to the first main side surface at a distant to the first main side surface.

The above embodiments were explained with specific conductivity types. The conductivity types of the semiconductor layers in the above described embodiments might be switched, so that all layers which were described as p-type layers would be n-type layers and all layers which were described as n-type layers would be p-type layers.

It should be noted that the term "comprising" does not exclude other elements or steps and that the indefinite article "a" or "an" does not exclude the plural. Also elements described in association with different embodiments may be combined.

### List of reference signs

- 1: first main side surface
- 2: second main side surface
- 3: n⁻ drift layer
- 4: n⁺ substrate layer
- 5: back metallization layer
- 6: p⁺ anode layer portion
- 7: top metallization layer
- 8: p⁺ junction termination ring
- 9: p⁺ (floating field or guard) ring
- 10: passivation layer
- 15: p⁻ junction termination extension (JTE)
- 20: p⁻ junction termination extension (JTE) ring
- 25: p⁺ guard ring
- 20': p⁻ junction termination extension (JTE) ring
- 25': p⁺ guard ring
- 20": p⁻ junction termination extension (JTE) ring
- 25'': p⁺ guard ring
- 20''': p⁻ junction termination extension (JTE) ring
- 25''': p⁺ guard ring
- 20'''': p⁻ junction termination extension (JTE) ring
- 25'''': p⁺ guard ring
- 30: charge compensation layer
- AR: active region
- TR: termination region
- W: semiconductor wafer

## Claims

1. High power semiconductor device comprising a semiconductor wafer (W), the wafer (W) having a first main side surface (1), a second main side surface (2), which is parallel to the first main side surface (1) and extending in a lateral direction, an active region (AR) and a termination region (TR) laterally surrounding the active region (AR), wherein:
the wafer (W) comprises in the order from the first main side surface (1) to the second main side surface (2):
(a) a first semiconductor layer (8) of a first conductivity type which is either n-type or p-type conductivity;
(b) a second semiconductor layer (3) of a second conductivity type which is different from the first conductivity type, wherein the second semiconductor layer (3) is in direct contact with the first semiconductor layer (8) to form a pn-junction; and
(c) a third semiconductor layer (4) of the second conductivity type having a doping concentration higher than that of the second semiconductor layer (3),
a first electrode layer (7) is formed on the first main side surface (1) to form a contact with the first semiconductor layer (8),
a second electrode (5) is formed on the second main side surface (2) to form a contact with the third semiconductor layer (4),
a plurality of junction termination extension rings (20) and a plurality of guard rings (25) are formed in the termination region (TR) adjacent to the first main side surface (1) of the wafer (W), wherein the number of guard rings is less than the number of termination extension rings,
each one of the junction termination extension rings (20) and of the guard rings (25) is a ring-shaped semiconductor region of the first conductivity type, which is laterally surrounding the active region (AR) and the first semiconductor layer,
the junction termination extension rings (20) are spaced from each other in the lateral direction,
the guard rings (25) are spaced from each other in the lateral direction,
the innermost guard ring (25) laterally surrounds the innermost junction termination extension ring (20) and is in direct contact with the second semiconductor layer (3),
at least two junction termination extension rings (20) laterally surround the outermost guard ring (25), and
the guard rings (25) have a doping concentration which is 5·10¹⁸ cm⁻³ or higher and the junction termination extension rings (20) have a doping concentration which is 8·10¹⁷ cm⁻³ or lower.

2. High power semiconductor device according to claim 1, wherein the innermost guard ring (25) links the two innermost junction termination extension rings (20) so that the two innermost junction termination extension rings (20) and the innermost guard ring (25) form a single continuous ling-shaped semiconductor region of the first conductivity type.

3. High power semiconductor device according to claim 1 or 2, wherein a first pair of two neighboring junction termination extension rings (20) is linked by a first guard ring (25) and a second pair of two neighboring junction termination extension rings (20) is linked by a second guard ring (25), wherein the first and the second pair of junction termination extension rings (20) include four neighboring junction termination extension rings (20), and wherein the first and the second guard ring (25) are two neighboring guard rings (25).

4. High power semiconductor device according to any one of claims 1 to 3, wherein the width of the guard rings (25) in the lateral direction is in a range of 1 µm to 5 µm.

5. High power semiconductor device according to any one of claims 1 to 4, wherein the width of the junction termination extension rings (20) in the lateral direction is in a range of 2 µm to 10 µm.

6. High power semiconductor device according to any one of claims 1 to 5, wherein depth of the junction termination extension rings (20) to which they extend from the first main side surface (1) is in a range between 0.4 and 5 µm.

7. High power semiconductor device according to any one of claims 1 to 6, wherein the number of the junction termination extension rings (20) is between 10 and 150.

8. High power semiconductor device according to any one of claims 1 to 7, wherein the number of the guard rings (25) is between 2 and 50.

9. High power semiconductor device according to any one of claims 1 to 8, wherein the innermost junction termination extension ring (20) laterally surrounds the first semiconductor layer (8) at a distance which is in a range between 0.5 to 5 µm.

10. High power semiconductor device according to any one of claims 1 to 9, wherein the guard rings (25) are buried in the wafer (W) separated from the first main side surface (1) at a distance of between 0.2 to 2 µm, preferably at a distance of between 0.2 and 1.5µm.

11. High power semiconductor device according to any one of claims 1 to 10, wherein the distance between neighboring junction termination extension rings (20) in the lateral direction is in a range of between 0.5 to 5 µm.

12. High power semiconductor device according to any one of claims 1 to 11, wherein the distance between neighboring guard rings (25) in the lateral direction is at least 3 µm.

13. High power semiconductor device according to any one of claims 1 to 12, wherein the first semiconductor layer (8) comprises a ring shaped semiconductor region which is formed along the edge of the active region (AR) and which is in direct contact with the first electrode (7).

14. High power semiconductor device according to any one of claims 1 to 13, wherein a charge compensation layer (30) is formed in the termination region (TR) of the wafer (W) at the first main side surface (1) of the wafer (W), and wherein the charge compensation layer (30) is a semiconductor layer of the second conductivity type having a doping concentration which is higher than that of the second semiconductor layer (3).

15. High power semiconductor device according to any one of claims 1 to 14, wherein the distance between neighboring junction termination extension rings (20), which are not linked by a guard ring (25), is increasing stepwise or continuously from the innermost pair of junction termination extension rings (20) to the outermost pair of junction termination extension rings (20).
